# EUROPÄISCHE PATENTANMELDUNG

(11) **EP 0 947 408 A2**
(43) Veröffentlichungstag der Anmeldung: **06.10.1999**
(21) Anmeldenummer: 99106564.0
(22) Anmeldetag: 30.03.1999
(51) Int. Cl.: B60T 8/36

(54) **Steuergerät für eine hydraulische Bremssteuerung und Herstellungsverfahren**

(30) Priorität: 30.03.1998 DE 19814157
(71) Anmelder: SIEMENS AKTIENGESELLSCHAFT, 80333 München (DE)
(72) Erfinder: Schöttl, Johannes, 93083 Obertraubling (DE)

(57) **Zusammenfassung**

Ein Steuergerät zum Aufsetzen auf einen Ventilblock (2) einer hydraulischen Bremssteuerung weist eine Leiterplatte (10) mit elektronischen Bauelementen (11) und Ventilspulen (12) auf, die mit der Leiterplatte elektrisch kontaktiert sind. Die Leiterplatte (10) ist vollständig von einem Gehäuse (13) aus Kunststoff umhüllt, so daß die elektronischen Bauelemente (11) mit dem Gehäuse (13) thermisch gekoppelt sind.

## Beschreibung

Die Erfindung betrifft ein Steuergerät zum Aufsetzen auf einen Ventilblock einer hydraulischen Bremssteuerung und ein Verfahren zur Herstellung eines solchen Steuergeräts.

Ein derartiges Steuergerät ist aus der Patentschrift 195 18 518 C1 bekannt. Das Steuergerät weist ein Gehäuse auf, in dem Ventilspulen und eine Leiterplatte mit einer elektronischen Steuerschaltung zum Steuern von Magnetventilen angeordnet sind. Die Leiterplatte ist mit einer Metallplatte als Kühlkörper versehen, um eine ausreichende Wärmeabführung von der Steuerschaltung zu gewährleisten. Beim Herstellungsprozeß muß zunächst ein Rahmen als Träger für die Ventilspulen gefertigt werden. Um die Ventilspulen elastisch im Rahmen zu lagern, sind die Ventilspulen in einer elastischen Kunststoffmasse eingebettet. Zur Herstellung des Rahmens und der Einbettung sind daher zwei Spritzvorgänge (Hart-/Weich-Verbund) nötig. Anschließend wird die bestückte Leiterplatte in den Rahmen eingesetzt, und es wird eine Lötverbindung mit den Ventilspulen hergestellt. Das nachträgliche Löten im Rahmen erfordert Freiräume auf der Leiterplatte, die nicht bestückt werden können. Schließlich muß der Rahmen mit einem Deckel verschlossen und abgedichtet werden.

Aus der internationalen Anmeldung Wo 95/20510 ist eine elektrohydraulische Druckregelvorrichtung bekannt, die ein Trägerelement mit darin eingegossenen Leiterbahnen aufweist. Elektronische Bauteile einer Steuervorrichtung können im Trägerelement eingespritzt sein. In Durchgangsöffnungen des Trägerelements werden Ventilspulen eingesetzt und mit den Leiterbahnen elektrisch kontaktiert. Die Durchgangsöffnungen müssen anschließend dicht verschlossen werden.

Die internationale Anmeldung WO 95/03960 betrifft eine elektrohydraulische Druckregelvorrichtung mit einem Formkörper aus Kunststoff. Der Formkörper wird um Spulen gespritzt, sobald diese mit Leiterbahnen oder einer Leiterplatte verlötet sind. Der Formkörper weist großzügig dimensionierte Durchgangsöffnungen zur Aufnahme der Ventildome eines Ventilaufnahmekörpers auf. Nachdem der Formkörper auf den Ventilaufnahmekörper aufgelegt ist, werden Spulenmantel von Außen auf die Ventildome aufgeschoben und gesichert. Anschließend müssen die Durchgangsöffnungen verschlossen und abgedichtet werden.

Aus der Offenlegungsschrift DE 44 22 491 A1 ist eine Druckregelvorrichtung mit einem als Stahlplatte ausgeführten Trägerelement bekannt. An der Unterseite des Trägerelements sind Rohrkörper und Hülsen von Spulen angeschweißt. Das Trägerelement weist Durchgangsbohrungen für Kontakte der Spulen auf. Diese Durchgangsbohrungen sind von einer Vergußmasse ausgefüllt. Auf dem Trägerelement sind Leiterbahnen und elektrische Bauteile angeordnet. Die gesamte Baugruppe ist mit dem Kunststoff des Gehäuses umspritzt.

Es ist ein Ziel der Erfindung, ein Steuergerät zum Aufsetzen auf einen Ventilblock einer hydraulischen Bremssteuerung bereitzustellen, das mit wenigen und einfachen Prozeßschritten hergestellt werden kann.

Dieses Ziel wird mit einem Steuergerät und einem Herstellungsverfahren erreicht, wie sie in den unabhängigen Patentansprüchen definiert sind. Zweckmäßige Weiterbildungen der Erfindung sind in den Unteransprüchen angegeben.

Als Leiterplatte kann sowohl ein flexibles als auch ein starres Material gewählt werden. Das Anbringen einer Kühlplatte ist nicht notwendig. Da die elektronischen Bauelemente thermisch mit dem wärmeleitenden Material des Gehäuses verbunden sind und keine isolierende Luftschicht über den Bauelementen vorhanden ist, können Temperaturspitzen, die bei den bekannten Steuergeräten trotz Kühlplatten aufgetreten sind, deutlich gesenkt werden. Deshalb können kostengünstigere elektronische Bauteile zum Einsatz kommen.

Die Leiterplatte oder eine an die Leiterplatte angebrachte Kühlplatte muß nicht zur Anlage an den Ventilblock gebracht und dort befestigt werden.

Beim Herstellen des Steuergeräts kann zunächst die Leiterplatte bestückt und die Ventilspulen können mit der Leiterplatte kontaktiert werden. Anschließend kann bereits vor dem Einbau in ein Gehäuse ein Funktionstest durchgeführt werden.

Ein dichtes Gehäuse läßt sich auf einfache Weise durch Umspritzen der Leiterplatte und der Ventilspulen aus Kunststoff bilden. Weist der Kunststoff des Gehäuses elastische Eigenschaften auf, so werden die Ventilspulen von dem Kunststoff elastisch oder nachgiebig gelagert, so daß bei der Montage des Steuergeräts auf den Ventilblock Fertigungstoleranzen des Ventilblocks ausgeglichen werden können.

In einer vorteilhaften Ausführungsform sind die Steckerstifte eines Steckverbinders in die Leiterplatte geführt. Die Steckerstifte werden vor der Bildung des Gehäuses mit den anderen Bauteilen an die Leiterplatte gelötet. Der Steckverbinder wird als Teil des Gehäuses an die Leiterplatte angespritzt.

Vorzugsweise sind die elektronischen Bauelemente, die Ventilspulen und die Steckerstifte eines Steckverbinders auf derselben Seite mit der Leiterplatte kontaktiert. Es muß daher nur eine Seite der Leiterplatte gelötet werden.

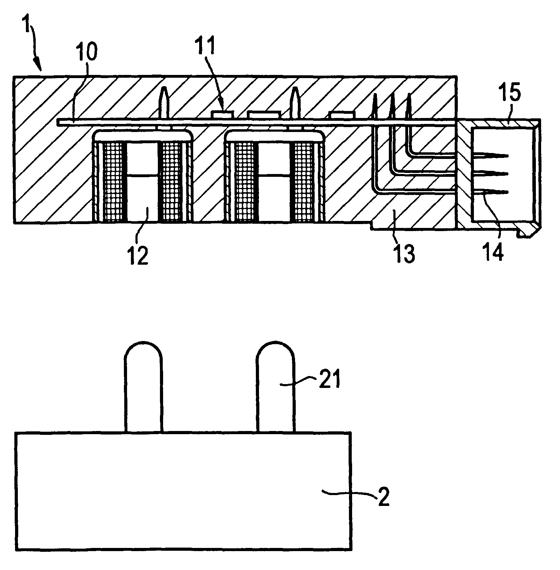

Weitere Vorteile, Merkmale und Anwendungsmöglichkeiten der Erfindung ergeben sich aus der nachfolgenden Beschreibung eines Ausführungsbeispiels in Verbindung mit der Zeichnung.

Die Figur zeigt ein Steuergerät vor dem Aufsetzen auf einen Ventilblock.

Ein Steuergerät 1 weist eine starre Leiterplatte 10 mit elektronischen Bauelementen 11 einer Ventilsteuerschaltung auf, die auf einer Seite der Leiterplatte 10 angeordnet sind. Ventilspulen 12 sind auf der gegenüberliegenden Seite der Leiterplatte 10 angeordnet.

Ein Gehäuse 13 aus einer Polyurethan-Masse umhüllt die Leiterplatte 10 und fixiert die Ventilspulen 12. Letztere sind in gewissem Umfang aufgrund der elastischen Eigenschaften des Polyurethans beweglich.

Da die Kunststoffmasse des Gehäuses 13 in flächigem Kontakt mit den elektronischen Bauelementen 11 steht, bei denen es sich um aktive Bauelemente handelt, ohne daß ein Luftspalt über den elektronischen Bauelementen 11 existiert, kann Verlustleistung der elektronischen Bauelemente 11 vom Körper des Gehäuses unmittelbar aufgenommen und abgeführt werden. Auf diese Weise werden Temperaturspitzen, die durch den unregelmäßigen Betrieb eines Antiblockiersystems bedingt sind, vermieden oder deutlich abgeflacht.

Steckerstifte 14 eines Steckverbinders 15 sind ebenfalls von der den elektronischen Bauelementen 11 abgewandten Seite der Leiterplatte 10 in dieselbe geführt. Wenn die elektronischen Bauelemente 11 SMDs (Surface Mounted Devices) sind, ist es daher ausreichend, lediglich eine Seite der Leiterplatte 10 zu löten.

Falls die für die Leiterplatte 10 zur Verfügung stehende Fläche begrenzt ist, können elektronische Bauelemente 11 auch auf der Seite angeordnet werden, an der sich die Ventilspulen 12 befinden. Die Leiterplatte 10 ist nicht an einer Auflage montiert, sondern allseitig von Kunststoffmaterial eingehüllt, das die elektronischen Bauelemente 11 schützt.

Das Gehäuse oder die Fassung des Steckverbinders 15 ist einstückig mit dem Gehäuse 13 des Steuergeräts 1 verbunden und ist zusammen mit demselben beim Umspritzen der Leiterplatte 10 mit Kunststoff hergestellt.

Das Steuergerät 1 ist dazu bestimmt, auf einen Ventilblock 2 einer hydraulischen Bremssteuerung montiert zu werden. Die Ventilspulen 12 werden hierbei auf Ventile 21 oder Ventildome gesteckt. Aufgrund der nachgiebigen oder elastischen Einbettung der Ventilspulen 12 in die Kunststoffmasse des Gehäuses 13 können gewisse Fertigungstoleranzen bei der Herstellung des Ventilblocks 2 ausgeglichen werden.

## Patentansprüche

1. Steuergerät zum Aufsetzen auf einen Ventilblock (2) einer hydraulischen Bremssteuerung, das aufweist:
- ein dichtes, einstückiges Gehäuse (13) aus elastischem Kunststoff,
- eine Leiterplatte (10) mit elektronischen Bauelementen (11) einer Schaltung zum Steuern von Ventilen (21), die vollständig vom einstückigen Gehäuse (13) umhüllt ist und deren elektronische Bauelemente (11) mit dem Gehäuse thermisch gekoppelt sind,
- mit der Leiterplatte (10) elektrisch kontaktierte Ventilspulen (12), die durch umspritzten, elastischen Kunststoff des einstückigen Gehäuses (13) elastisch gelagert sind.

2. Steuergerät nach Ansprüch 1, dadurch gekennzeichnet, daß ein Steckverbinder (15) einstückig an das Gehäuse (13) angeformt ist, dessen Steckerstifte (14) in die Leiterplatte (10) geführt sind.

3. Steuergerät nach dem vorhergehenden Anspruch, dadurch gekennzeichnet, daß die Leiterplatte (10) nur auf einer Seite mit elektonischen Bauelementen (11) bestückt ist, und daß die Ventilspulen (12) und die Steckerstifte (14) auf der Seite mit den elektronischen Bauelementen mit der Leiterplatte (10) kontaktiert sind.

4. Verfahren zum Herstellen eines Steuergeräts zum Aufsetzen auf einen Ventilblock (2) einer hydraulischen Bremssteuerung, mit den Schritten:
- eine Leiterplatte (10) wird mit elektronischen Bauelementen (11) einer Schaltung zum Steuern von Ventilen (21) bestuckt,
- die Leiterplatte (10) wird mit Ventilspulen (12) elektrisch kontaktiert,
- ein dichtes, einstückiges Gehäuse (13) wird gebildet, indem die Leiterplatte (10) und die Ventilspulen (12) mit elastischem Kunststoff derart umspritzt werden, daß die Leiterplatte (10) vollständig mit elastischem Kunststoff umgeben wird und die elektronischen Bauelmente (11) mit dem Kunststoffmaterial des Gehäuses (13) thermisch gekoppelt werden.
